# EUROPEAN PATENT APPLICATION

(11) **EP 4 447 049 A1**
(43) Date of publication of application: **16.10.2024**
(21) Application number: 24157343.5
(22) Date of filing: 13.02.2024
(51) Int. Cl.: G11C 5/02, G11C 7/18, H10B 41/20, H10B 41/40

(54) **MEMORY DEVICE WITH INTERPLANE PAD PART**

(30) Priority: 28.02.2023 KR 20230027220
(71) Applicant: Samsung Electronics Co., Ltd., Suwon-si, Gyeonggi-do 16677 (KR)
(72) Inventor: LEE, Myunghun, 16677 Suwon-si, Gyeonggi-do (KR); SHIN, Homoon, 16677 Suwon-si, Gyeonggi-do (KR)
(74) Representative: Kuhnen & Wacker Patent- und Rechtsanwaltsbüro PartG mbB

(57) **Abstract**

A memory device may include a first structure (ST1) and a second structure (ST2) bonded to the first structure (ST1). The first structure (ST1) may have a plurality of planes (PL1-PL6) and a pad part (PDP; PDP1, PDP2) between two planes adjacent to each other among the plurality of planes (PL1-PL6). Each of the plurality of planes (PL1-PL6) may include a memory cell. The second structure (ST2) may include a peripheral circuit. The plurality of planes (PL1-PL6) may be minimum units in which operations are independently performed and may be in an n x m array (n and m being integers of 2 or larger). The pad part (PDP; PDP1, PDP2) may be between the rows and/or between the columns of the n x m array.

## Description

### BACKGROUND

Embodiments of the present disclosure described herein relate to a semiconductor memory device, and more particularly, relate to a memory device having an inter-plane pad part.

Semiconductor memory devices include volatile memory devices and non-volatile memory devices. While read and write speeds of the volatile memory devices are fast, contents stored in the volatile memory devices may be lost when power is turned off. In contrast, the non-volatile memory devices maintain stored contents even when power is turned off. Accordingly, the non-volatile memory devices are used to store contents that have to be maintained irrespective of whether power is supplied.

For example, the volatile memory devices include a static RAM (SRAM), a dynamic RAM (DRAM), a synchronous DRAM (SDRAM), and the like. The non-volatile memory devices maintain stored contents even when power is turned off.

These memory devices may be manufactured in the form of a memory chip and used in a stacked form. In a conventional memory device, pad parts of memory chips are disposed at edges of the memory chips, and when the memory chips are stacked, the memory chips are connected to each other using wires. However, in this case, the size of the memory device is increased, and signal delay may occur due to the placement of the pad parts at the edges of the memory chips.

### SUMMARY

Embodiments of the present disclosure provide a high-quality memory device having a small volume while solving problems such as a signal delay.

According to an embodiment, a memory device may include a first structure and a second structure bonded to the first structure. The first structure may have a plurality of planes and a pad part between two planes adjacent to each other among the plurality of planes. Each of the plurality of planes may include a memory cell. The second structure may include a peripheral circuit. The plurality of planes may be minimum units in which operations are independently performed and may be in an n x m array, where n and m each independently may be integers of 2 or larger. The pad part may be between the rows of the n x m array, the columns of the n x m array, or both the rows of the n x m array and the columns of the n x m array.

In some embodiments, a first surface of the first structure may face the second structure, a second surface of the first structure may face away from the first surface of the first structure, a first surface of the second structure may face the first structure, and a second surface of the second structure may face away from the first surface of the second structure. The pad part may include a first signal pad on the second surface of the first structure and a second signal pad on the second surface of the second structure.

In some embodiments, the first signal pad may be one among a number of first signal pads on the second surface of the first structure, the second signal pad may be one among a number of second signal pads on the second surface of the second structure, and the number of first signal pads and the number of second signal pads may differ from each other.

In some embodiments, the memory device may further include a first rear metal layer on the second surface of the first structure; and a second rear metal layer on the second surface of the second structure. A material of the first signal pad may be the same as a material as the first rear metal layer, and a material of the second signal pad may be the same as a material of the second rear metal layer.

In some embodiments, the memory device may further include a first cover layer on the first signal pad and the first rear metal layer, the first cover layer having an opening exposing an upper surface of the first signal pad; and a second cover layer on the second signal pad and the second rear metal layer, the second cover layer having an opening exposing an upper surface of the second signal pad.

In some embodiments, the pad part may further include a pad VIA overlapping the first signal pad when viewed from above a plane, and the pad VIA may penetrate the first structure between the a first plane and a second plane among the plurality of planes.

In some embodiments, the opening of the first cover layer may be one of a plurality of openings in the first cover layer exposing the upper surface of the first signal pad, the opening of the second cover layer may be one of a plurality of openings in the second cover layer exposing the upper surface of the second signal pad, or the first cover layer may include the plurality of openings in the first cover layer exposing the upper surface of the first signal pad and the second cover layer includes the plurality of openings in the second cover layer exposing the upper surface of the second signal pad.

In some embodiments, the opening of the first cover layer exposing the upper surface of the first signal pad may at least partially overlap a first plane and a second plane among the plurality of planes when viewed from above a plane.

In some embodiments, the columns of the plurality of planes may extend in a first direction, the rows of the plurality of planes may extend in a second direction, and the pad part may include a first pad part between two planes arranged in the first direction and a second pad part between two planes arranged in the second direction.

In some embodiments, at least one of the first pad part and the second pad part may be connected to the memory cell of a corresponding plane among the plurality of planes, the peripheral circuit, or both peripheral circuit and the memory cell of the corresponding plane.

In some embodiments, the first structure may be one of a plurality of first structures in the memory device. The second structure may be one of a plurality of second structures in the memory device. The memory device may include two or more memory chips stacked on each other to provide stacked memory chips. Each memory chip of the two or more memory chips may be constituted by a corresponding one of the first structures and a corresponding one the second structures stacked on each other.

In some embodiments, the stacked memory chips may be bonded by flip-chip bonding.

In some embodiments, the pad part may further include a bypass pad part passing through one of the stacked memory chips and electrically connecting memory chips that are not directly adjacent to each other.

In some embodiments, the stacked memory chips may include three or more memory chips stacked on each other and at least some memory chips in the stacked memory chips are connected through the bypass pad part.

In some embodiments, the pad part may further include a through-VIA penetrating the first structure and connecting to the peripheral circuit.

In some embodiments, the first structure may be one of a plurality of first structures, and the plurality of first structures may be sequentially stacked on the second structure and directly bonded to the second structure.

According to an embodiment, a method for manufacturing a memory device may include manufacturing a first structure, the first structure including a plurality of planes, and a pad part between two planes adjacent to each other among the plurality of planes, each of the plurality of planes including a memory cell; manufacturing a second structure including a peripheral circuit; and placing the first structure turned upside down on the second structure and directly bonding the first structure and the second structure to each other.

In some embodiments, the method may further include simultaneously forming a first rear metal layer and a first signal pad on a second surface of the first structure; and simultaneously forming a second rear metal layer and a second signal pad on a second surface of the second structure.

According to an embodiment, a method for manufacturing a memory device may include manufacturing a first structure, the first structure including a plurality of planes, and a pad part between two planes adjacent to each other among the plurality of planes, each of the plurality of planes including a memory cell; manufacturing a second structure including a peripheral circuit; manufacturing a memory chip by placing the first structure turned upside down on the second structure and directly bonding the first structure and the second structure to each other; and stacking and flip-bonding a plurality of manufactured memory chips.

### BRIEF DESCRIPTION OF THE FIGURES

The above and other objects and features of the present disclosure will become apparent by describing in detail embodiments thereof with reference to the accompanying drawings.
FIG. 1 is a block diagram of a memory device according to an embodiment of the present disclosure.
FIG. 2 is a schematic circuit diagram of a memory block BLK included in the memory device according to an embodiment of the present disclosure.
FIG. 3 is a schematic exploded perspective view of the memory device according to an embodiment of the present disclosure.
FIGS. 4a and 4b illustrate memory devices formed by stacking a plurality of memory chips, where FIG. 4a illustrates a memory device in the related art, and FIG. 4b illustrates the memory device according to an embodiment of the present disclosure.
FIG. 5a is a sectional view of the memory device taken along line A-A' of FIG. 3 according to an embodiment of the present disclosure, and FIG. 5b is a plan view of a portion corresponding to P1 of FIG. 5a.
FIG. 6 is a sectional view illustrating the memory device according to an embodiment of the present disclosure.
FIG. 7a is a sectional view of the memory device according to an embodiment of the present disclosure, and FIG. 7b is a plan view of a portion corresponding to P2 of FIG. 7a.
FIG. 8 is a sectional view illustrating the memory device according to an embodiment of the present disclosure, where a pad part has a through-VIA.
FIG. 9 is a schematic plan view illustrating the memory device according to an embodiment of the present disclosure.
FIG. 10 is a schematic sectional view of the memory device having a bypass path according to an embodiment of the present disclosure.
FIG. 11 is a sectional view illustrating a memory chip having a bypass pad part in the memory device according to an embodiment of the present disclosure.
FIGS. 12a and 12b are schematic views illustrating the shortest signal transmission paths in an existing memory device and the memory device according to an embodiment of the present disclosure.

### DETAILED DESCRIPTION

Various changes can be made to the present disclosure, and various embodiments of the present disclosure may be implemented. Thus, specific embodiments are illustrated in the drawings and described as examples herein. However, it should be understood that the present disclosure is not to be construed as being limited thereto and covers all modifications, equivalents, and alternatives falling within the spirit and scope of the present disclosure.

In this specification, when a component is mentioned as being on another component, it means that the component is directly formed on the other component or a third component may be interposed therebetween. Furthermore, in the drawings, the thicknesses of components are exaggerated for effective description of technical contents.

Terms used herein are only for description of embodiments and are not intended to limit the present disclosure. As used herein, the singular forms are intended to include the plural forms as well, unless context clearly indicates otherwise. It will be further understood that the terms "comprise" and/or "comprising" specify the presence of stated features or components, but do not preclude the presence or addition of one or more other features or components.

An embodiment of the present disclosure relates to a memory device. The memory device may be an electrically erasable programmable read-only memory (EEPROM), a flash memory, a phase change random access memory (PRAM), a resistance random access memory (RRAM), a magnetic random access memory (MRAM), a ferroelectric random access memory (FRAM), or a combination thereof that is capable of retaining stored data even though power supply is cut off. Hereinafter, for convenience of description, embodiments of the present disclosure will be described in more detail under the assumption that the memory device is a flash memory.

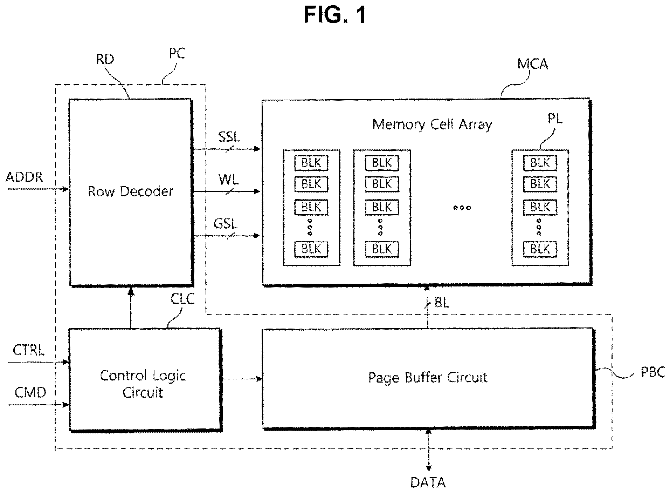

FIG. 1 is a block diagram of the memory device according to an embodiment of the present disclosure.

Referring to FIG. 1, the memory device includes a memory cell array MCA and a peripheral circuit PC. The memory cell array MCA may include a plurality of planes PL, and each of the planes PL corresponds to a minimum unit in which an operation such as a read, write, or erase operation is independently performed. When the memory cell array MCA includes the plurality of planes PL, a plurality of operations may be simultaneously performed in the plurality of planes PL, respectively. Each of the planes PL includes a plurality of memory blocks BLK. Each of the memory blocks BLK may include a plurality of pages, and each of the pages may include a plurality of memory cells capable of performing read and write operations and storing data.

The peripheral circuit PC may include a row decoder RD, a page buffer circuit PBC, and a control logic circuit CLC. The row decoder RD is connected to the memory cell array MCA by a plurality of string selection lines SSL, a plurality of word lines WL, and a plurality of ground selection lines GSL. The row decoder RD may select at least one of the plurality of memory blocks BLK in the memory cell array MCA in response to an address ADDR provided from a memory controller (not illustrated). Furthermore, the row decoder RD may select at least one of the word lines WL, the string selection lines SSL, and the ground selection lines GSL of the memory block BLK selected in response to the address ADDR provided from the memory controller (not illustrated).

The page buffer circuit PBC is connected to the memory cell array MCA through a plurality of bit lines BL. The page buffer circuit PBC may select at least one of the bit lines BL. The page buffer circuit PBC may store data DATA input from the memory controller (not illustrated) in the memory cell array MCA. Furthermore, the page buffer circuit PBC may output data DATA read out of the memory cell array MCA to the memory controller (not illustrated).

The control logic circuit CLC may control overall operation of the memory device. Specifically, the control logic circuit CLC may control operations of the row decoder RD and the page buffer circuit PBC. For example, the control logic circuit CLC may control the memory device such that a memory operation corresponding to a command CMD provided from the memory controller (not illustrated) is performed. In addition, in response to a control signal CTRL provided from the memory controller (not illustrated), the control logic circuit CLC may generate various internal control signals used in the memory device.

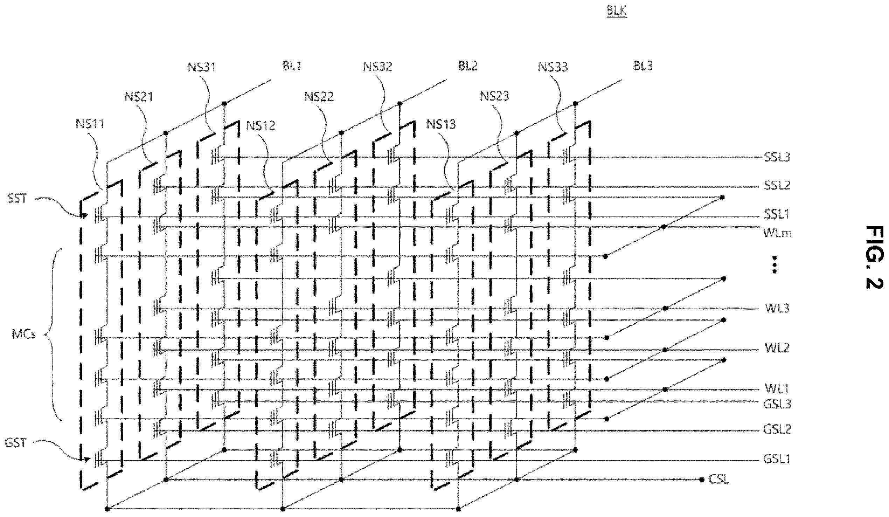

FIG. 2 is a schematic circuit diagram of a memory block included in the memory device according to an embodiment of the present disclosure. The memory block BLK is implemented in three dimensions and will be described based on X, Y, and Z directions for convenience of description. However, these directions are for reference only and may be different from the directions illustrated in this drawing when implemented in an actual device.

Referring to FIG. 2, the memory block BLK may include a plurality of NAND strings NS11 to NS33. Although FIG. 2 illustrates an example that one memory block BLK includes nine NAND strings NS11 to NS33, the number of NAND strings included in one memory block BLK is not limited thereto. Each of the NAND strings NS11 to NS33 may extend in a vertical direction (e.g., the Z direction). Each of the NAND strings NS11 to NS 33 may include at least one string selection transistor SST connected in series, a plurality of memory cells MCs, and at least one ground selection transistor GST. Although FIG. 2 illustrates an example that each of the NAND strings NS11 to NS33 includes one string selection transistor SST, eight memory cells MC1 to MC8, and one ground selection transistor GST, the numbers of string selection transistors, memory cells, and ground selection transistors included in each of the NAND strings NS11 to NS33 are not limited thereto. In some embodiments, each of the NAND strings NS11 to NS33 may further include a dummy memory cell (not illustrated) between at least one ground selection transistor GST and the memory cell MC. In some embodiments, each of the NAND strings NS11 to NS33 may further include a dummy memory cell (not illustrated) between the memory cell MC and at least one string selection transistor SST.

The NAND strings NS11 to NS33 may be connected between bit lines BL1 to BL3 and a common source line CSL. Each of the bit lines BL1 to BL3 may extend in a second horizontal direction (e.g., the Y direction). Gates of the string selection transistors SST may be connected to string selection lines SSL1 to SSL3, gates of the memory cells MCs may be connected to word lines WL1 to WLm, and gates of the ground selection transistors GST may be connected to ground selection lines GSL1 to GSL3. Each of the string selection lines SSL1 to SSL3, each of the word lines WL1 to WLm, and each of the ground selection lines GSL1 to GSL3 may extend in a first horizontal direction (e.g., the X direction). The common source line CSL may be commonly connected to the plurality of NAND strings NS11 to NS33. In addition, the word lines WL1 to WLm may be commonly connected to the plurality of NAND strings NS11 to NS33.

In an embodiment of the present disclosure, one plane PL may include a plurality of memory blocks BLK that share bit lines BL1 to BL3. For example, one plane PL may include a plurality of memory blocks BLK arranged in the Y direction in FIG. 2. One memory block BLK may be constituted by a plurality of pages, and one page may be represented by a set of memory cells connected to the same word line. For example, nine first memory cells MC1 at the same height in the Z direction in FIG. 2 may constitute one page.

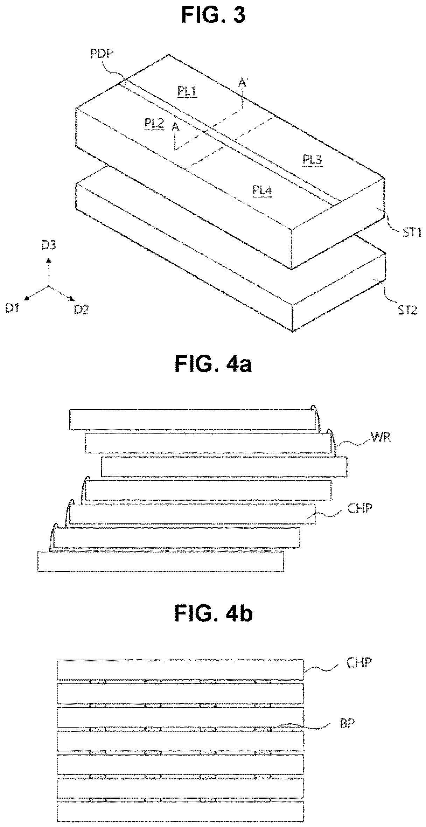

FIG. 3 is a schematic exploded perspective view of the memory device according to an embodiment of the present disclosure.

Referring to FIG. 3, the memory device according to an embodiment of the present disclosure includes a first structure ST1 including a 3D memory cell array, a second structure ST2 including a peripheral circuit configured to control an operation of the memory cell array, and a pad part PDP for connection with other components.

The memory device according to an embodiment of the present disclosure may be implemented in a chip to chip (C2C) structure. The C2C structure may mean manufacturing at least one upper chip (the first structure ST1 in this embodiment) including a memory cell array and a lower chip (the second structure ST2 in this embodiment) including a peripheral circuit region and thereafter connecting the upper chip and the lower chip by bonding. The upper chip may be turned upside down and may be connected to the lower chip by bonding.

Accordingly, it should be understood that in the following description, a front and a rear surface or an upper surface and a lower surface are referred to, based on before the first structure ST1 is turned upside down.

The first structure ST1 includes a plurality of planes. In an embodiment of the present disclosure, at least two planes PL may be provided. For example, four or more planes PL may be provided. In an embodiment of the present disclosure, first to fourth planes PL (PL1, PL2, PL3, and PL4) are illustrated as an example.

The planes PL are minimum units in which operations are independently performed. Each of the planes PL includes a memory cell formed on a first substrate SUB1. The memory cell is formed by alternately stacking conductive layers and insulating layers on the first substrate SUB1, and description thereabout will be given below.

The plurality of planes PL may be disposed in various forms. For example, the plurality of planes PL may be arranged in an n x m array ("n" and "m" being integers of 2 or larger). In arrangement directions of the planes PL, a column direction is referred to as a first direction D1, a row direction is referred to as a second direction D2. In an embodiment of the present disclosure, the first to fourth planes PL1, PL2, PL3, and PL4 of the first structure ST1 are illustrated as being arranged in a 2 x 2 array. However, this is only one embodiment, and the present disclosure is not limited thereto. For example, the number of planes PL may be 2, 3, 5, or more. Furthermore, the planes PL may be arranged in a form different from that illustrated in FIG. 3. The memory device according to an embodiment of the present disclosure will be described under the assumption that the memory device has the plane arrangement illustrated in FIG. 3. When the planes PL are arranged in an array form, this may mean not only that the planes PL have substantially the same shape or size and are completely aligned in a specific direction, but also that the planes PL have different shapes or sizes and are arranged in the first direction D1 and/or the second direction D2. For example, the planes PL may have different sizes and may be arranged in zigzags in a row or column direction.

The second structure ST2 includes the peripheral circuit that includes semiconductor elements, such as transistors, and patterns for connecting the elements through wires.

In an embodiment of the present disclosure, the first structure ST1 and the second structure ST2 are stacked and electrically connected.

The peripheral circuit of the second structure ST2 may be connected with the plurality of planes PL1, PL2, PL3, and PL4 of the first structure ST1. The peripheral circuit corresponding to each of the plurality of planes PL may independently operate. For example, independent control signals may be input to the plurality of planes PL1, PL2, PL3, and PL4 from the peripheral circuit. The plurality of planes PL1, PL2, PL3, and PL4, to which one of the control signals is input, may perform an operation depending on the input control signal. The operation of the plurality of planes PL1, PL2, PL3, and PL4 may be one of read, program, and erase operations, and the plurality of planes PL1, PL2, PL3, and PL4 may simultaneously perform different operations.

The pad part PDP, which is a part where a signal pad for electrical connection between each component of the first and second structures ST1 and ST2 and the outside is provided, has an inter-plane pad structure provided between two planes PL adjacent to each other among the plurality of planes PL. For example, the pad part PDP may be provided between the first plane PL1 and the second plane PL2 adjacent to each other in the first direction and/or between the third plane PL3 and the fourth plane PL4 adjacent to each other in the first direction. The pad part PDP is disposed between the plurality of planes PL and is not provided outside the outermost row and column on an array.

The first structure ST1 and the second structure ST2 of the above-described memory device may be bonded to constitute one memory chip. Although the first structure ST1 and the second structure ST2 constitute one memory chip in this embodiment, more structures may constitute one memory chip. For example, two first structures may be sequentially stacked on the second structure, or three or more first structures may be sequentially stacked on the second structure.

Furthermore, one memory chip may be used alone, but is not limited thereto. For example, a plurality of memory chips, each of which is constituted by the first structure ST1 and the second structure ST2 bonded to each other, may be stacked to form a memory device.

FIGS. 4a and 4b illustrate memory devices formed by stacking a plurality of memory chips. FIG. 4a illustrates a memory device in the related art, and FIG. 4b illustrates the memory device according to an embodiment of the present disclosure.

Referring to FIGS. 4a and 4b, when a plurality of memory chips CHP are provided and stacked in the related art, the memory chips CHP may be connected together through wire bonding using metal wires WR. However, unlike in the related art, a plurality of memory chips CHP according to example embodiments in the present disclosure may be connected through flip-chip bonding using bumps BP.

In more detail, in the memory device in the related art, the plurality of memory chips CHP are stacked in the vertical direction and wire-bonded through pad parts disposed on the peripheries of the memory chips CHP. In this case, to connect the stacked memory chips CHP using the wires WR, the pad parts on the peripheries of the memory chips CHP have to be exposed. Due to this, the memory chips CHP are sequentially disposed in a stair form, which leads to an increase in the width of the memory device.

In contrast, in the memory device according to the embodiment of the present disclosure, the plurality of memory chips CHP are stacked in the vertical direction and bonded through pad parts disposed inside the memory chips CHP. Accordingly, without the need to arrange the memory chips CHP in a stair form, the plurality of memory chips CHP may be vertically stacked while maintaining the width of one memory chip CHP. When the memory chips CHP in the embodiment of the present disclosure are stacked, the memory chips CHP may be connected through flip-chip bonding. For example, bumps BP, such as solder balls, are provided between two memory chips CHP to connect the two memory chips CHP. In this case, the bumps BP, such as solder balls, may be formed on pad parts of one of the two memory chips CHP, and the one memory chip CHP may be flipped and disposed on pad parts of the other memory chip CHP. Thereafter, the two memory chips CHP may be connected through a reflow process.

Hereinafter, some example embodiments of the first structure ST1 and the second structure ST2 constituting the memory chip CHP will be described in detail.

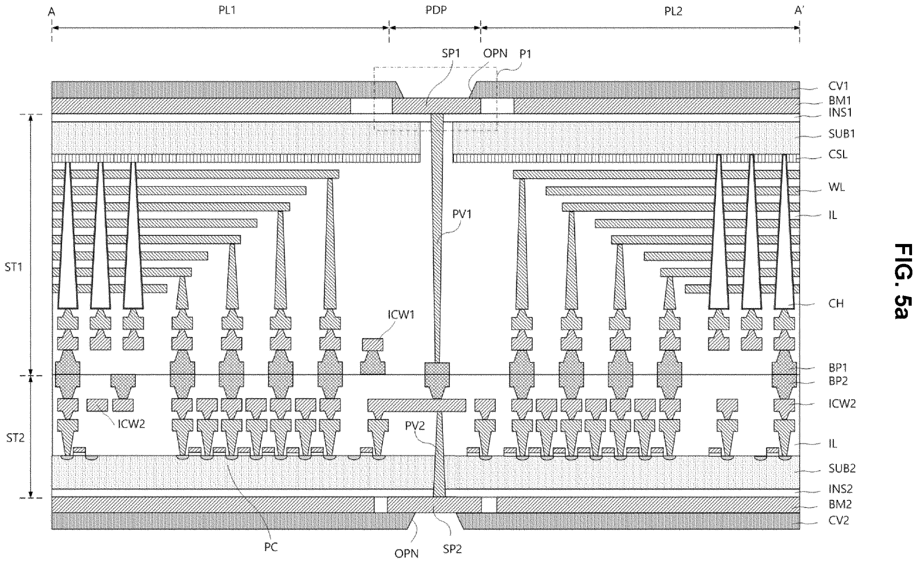

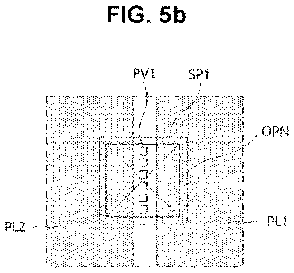

FIG. 5a is a sectional view of the memory device taken along line A-A' of FIG. 3 according to an embodiment of the present disclosure. FIG. 5b is a plan view of a portion corresponding to P1 of FIG. 5a.

Referring to FIGS. 5a and 5b, the first structure ST1 may be provided on the second structure ST2. The first structure ST1 may be directly bonded to the second structure ST2.

In the first structure ST1, each plane PL (the first plane PL1 and the second plane PL2 in the drawings) may include a first substrate SUB1, a plurality of word lines WL on the first substrate SUB1, and a plurality of channel structures CH penetrating the plurality of word lines WL.

The first substrate SUB 1 may include a semiconductor material such as silicon, germanium, or silicon-germanium, or a group III-V compound such as GaP, GaAs, or GaSb. According to some embodiments, the first substrate may be a silicon-on-insulator (SOI) substrate or a germanium-on-insulator (GOI) substrate.

A common source line CSL is provided on the first substrate SUB 1. The common source line CSL may include a semiconductor material such as a group IV semiconductor material, a group III-V semiconductor material, or a group II-VI semiconductor material. In some embodiments, the common source line CSL may be a portion of a Si epitaxial layer or a portion of a Si wafer.

The plurality of word lines WL and the channel structures CH provided on the first substrate SUB 1 may form one of the plurality of NAND strings NS 11 to NS33 illustrated in FIG. 2.

The plurality of word lines WL may have a stair shape, and an interlayer insulating layer IL is provided between the word lines WL. The interlayer insulating layer IL may include an insulating material including silicon oxide, silicon nitride, a low-k material, or a combination thereof. The low-k material may be a material having a lower dielectric constant than silicon oxide. For example, the low-k material may include phosphosilicate glass (PSG), borophosphosilicate glass(BPSG), fluorosilicate glass(FSG), organosilicate glass(OSG), spin-on-glass(SOG), spin-on-polymer, or a combination thereof. The plurality of word lines WL may include tungsten (W), copper (Cu), silver (Ag), gold (Au), aluminum (Al), or a combination thereof, but may include a conductive material not limited thereto.

The channel structures CH penetrate the plurality of word lines WL and the interlayer insulating layer IL. The channel structures CH may include a channel and a charge storage structure surrounding the channel.

The first structure ST1 and the second structure ST2 may include first and second internal connection wire ICW1 and ICW2. Although only parts of the first and second internal connection wires ICW1 and ICW2 are illustrated in the drawing, the present disclosure is not limited thereto, and the first internal connection wire ICW1 may further include a plurality of lines, interlayer VIAs, plugs, and the like. The first and second internal connection wires ICW1 and ICW2 may further include a barrier material such as titanium (Ti), tantalum (Ta), titanium nitride (TiN), or tantalum nitride (TaN).

In some embodiments, the first planes PL1 may have the same planar area. Likewise, the second planes PL2 may have the same planar area. The planar area of one first plane PL1 may be different from the planar area of one second plane PL2.

In the first and second structures ST1 and ST2, surfaces of the first and second structures ST1 and ST2 that face each other are referred to as first surfaces, and surfaces facing away from the first surfaces are referred to as second surfaces. A first bonding pad BP1 and a second bonding pad BP2 for direct bonding of the first structure ST1 and the second structure ST2 are provided on the first surfaces of the first structure ST1 and the second structure ST2. The first bonding pad BP1 and the second bonding pad BP2 may be provided not only on the pad part but also on regions that correspond to the first plane PL1 and the second plane PL2.

The first and second bonding pads BP1 and BP2 may include copper. However, without being limited thereto, the first and second bonding pads BP1 and BP2 may be formed of various metallic materials, for example, aluminum (Al) or tungsten (W).

In the first and second structures ST1 and ST2, the facing surfaces may be bonded to each other without the wires WR or the bumps BP for connecting the first structure ST1 and the second structure ST2. That is, the first structure ST1 may be directly bonded to the second structure ST2. For the direct bonding, the first and second structures ST1 and ST2 include the first and second bonding pads BP1 and BP2 facing each other. The first and second bonding pads BP1 and BP2 may be physically and electrically connected with each other by direct bonding. The first and second bonding pads BP1 and BP2 may include a conductive material including copper (Cu), gold (Au), silver (Ag), aluminum (Al), tungsten (W), titanium (Ti), tantalum (Ta), or a combination thereof.

A first signal pad PS1 is provided on the second surface of the first structure ST1, and a second signal pad SP2 is provided on the second surface of the second structure ST2. A first rear insulating layer INS1 may be interposed between the first signal pad SP1 and the first substrate SUB 1, and a second rear insulating layer INS2 may be interposed between the second signal pad SP2 and a second substrate SUB2. Between the first and second planes PL1 and PL2, the first signal pad SP1 and the second signal pad SP2 may be connected with various circuit wires in the first and second structures ST1 and ST2 through first and second pad VIAs PV1 and PV2 penetrating the first and second rear insulating layers INS 1 and INS2. Here, various electrical signals including power may be applied to the first signal pad SP1 and the second signal pad SP2.

The first signal pad SP1 and/or the second signal pad SP2, when viewed from above the plane, may partially overlap the first plane PL1 and/or the second plane PL2. For example, as illustrated in FIG. 5b, one side of the first signal pad SP1 may overlap the first plane PL1, and an opposite side of the first signal pad SP1 may overlap the second plane PL2. The first pad VIA PV1 is provided between the first plane PL1 and the second plane PL2. A single first pad VIA PV1 may be provided. However, a plurality of first pad VIAs PV1 may be provided as in this embodiment.

First and second rear metal layers BM1 and BM2 are provided on a second surface of the first substrate SUB1 and a second surface of the second substrate SUB2, respectively. The first and second rear metal layers BM1 and BM2 may include various conductive metallic materials, for example, aluminum.

In an embodiment of the present disclosure, the first rear metal layer BM1 and the first signal pad SP1 may be formed in separate processes or a same process. For example, the first rear metal layer BM1 and the first signal pad SP1 may be simultaneously formed of the same material in a single process. The second rear metal layer BM2 and the second signal pad SP2 may also be formed in separate processes or a same process.

First and second cover layers CV1 and CV2 are provided on the first and second rear metal layers BM1 and BM2. The first and second cover layers CV1 and CV2 have openings OPN that expose upper surfaces of the first and second signal pads SP1 and SP2, respectively. The exposed upper surfaces of the first and second signal pads SP1 and SP2 may be electrically connected with other components through flip-chip bonding.

In the above description, the one first signal pad SP1 and the one second signal pad SP2 are illustrated. However, this is only for convenience of description, and without being limited thereto, a plurality of first signal pads SP1 and a plurality of second signal pads SP2 may be provided. In addition, the pad part PDP may further include other wires having various forms, in addition to the first signal pad SP1 and the second signal pad SP2. Furthermore, in some embodiments, at least a part of other circuits included in the region of the peripheral circuit PC may be disposed in the pad part PDP.

The connection relationship between the wires will be described in more detail. The first signal pad SP1 of the pad part PDP is connected to the first bonding pad DB1 through the first pad VIA PV1 penetrating the inside of the first structure ST1. Between the two planes, the first pad VIA PV1 is provided in a through-hole formed through the first rear insulating layer INS1 and the first substrate SUB 1. The first pad VIA PV1 may be connected to the first bonding pad BP1 through the first internal connection wires ICW1 in the first structure ST1 and interlayer VIAs provided between the first internal connection wires ICW1.

The second boding pad BP2 of the second structure ST2 may be connected to the second internal connection wire ICW2 or the peripheral circuit PC including a transistor and a wire through an interlayer VIA and the second pad VIA PV2. In particular, the second bonding pad BP2 may be connected to the second signal pad SP2 through the second internal connection wire ICW2.

When the first and second bonding pads BP1 and BP2 of the first and second structures ST1 and ST2 are directly bonded to each other, the first signal pad SP1 may be connected with the second signal pad SP2 through the internal electrical connection structure.

In an embodiment of the present disclosure, the memory device having the above-described structure may be changed in various forms without departing from the spirit and scope of the present disclosure.

For example, the first and second signal pads SP1 and SP2, when viewed from above the plane, may be disposed in different positions rather than the same position. In an embodiment of the present disclosure, the first signal pad SP1 and the second signal pad SP2 may be disposed in substantially the same position, that is, on the same vertical line. However, without being limited thereto, the first signal pad SP1 and the second signal pad SP2 may be disposed in different positions in the vertical direction. In other words, in an embodiment of the present disclosure, the first signal pad SP1 and the second signal pad SP2, when viewed from above the plane, may be disposed in substantially the same position to overlap each other. However, without being limited thereto, the first signal pad SP1 and the second signal pad SP2, when viewed from above the plane, may partially overlap each other, or may not overlap each other.

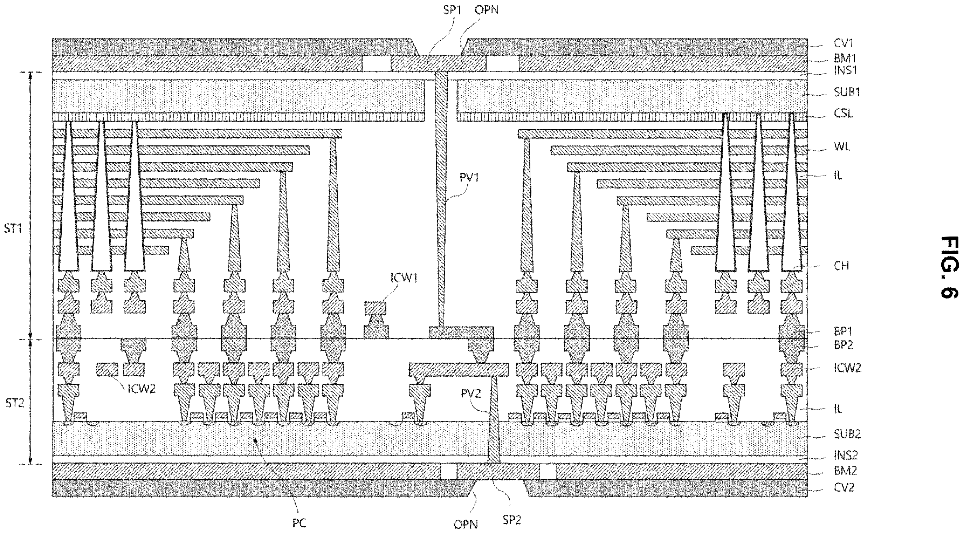

FIG. 6 is a sectional view illustrating the memory device according to an embodiment of the present disclosure. FIG. 6 illustrates a case in which the first signal pad SP1 and the second signal pad SP2 are not located on the same line in the stack direction of the first and second structures ST1 and ST2.

Since the pad part PDP is provided between the planes of the two structures in the present disclosure, the loading of power or signals is significantly reduced. Accordingly, the degree of freedom in design of wires constituting the pad part PDP is increased, and the positions of the first and second signal pads SP1 and SP2 may be freely changed within a range that satisfies this requirement.

The first signal pad SP1 and/or the second signal pad SP2 may be used as a plurality of signal pads that provide the same signal depending on the opening OPN of the first cover layer CV1 and/or the second cover layer CV2.

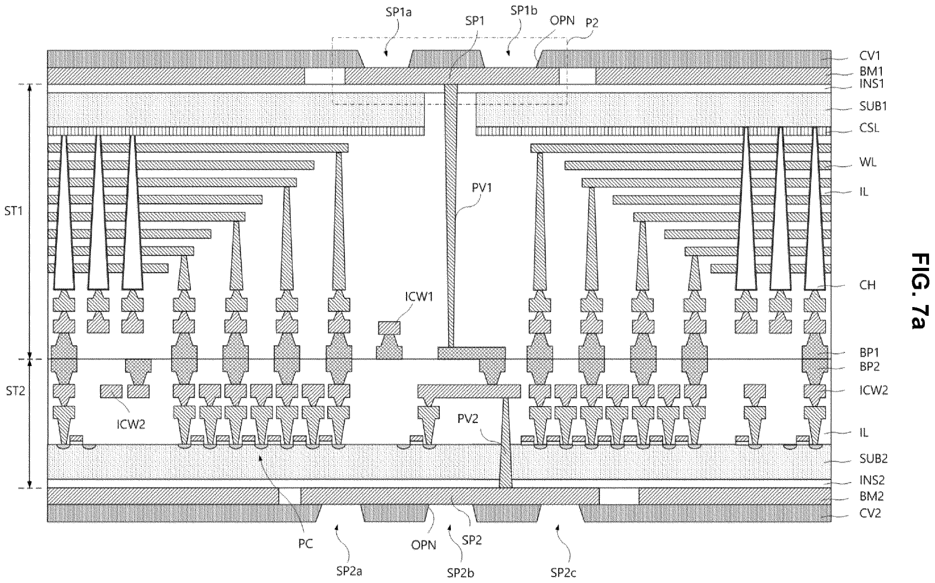

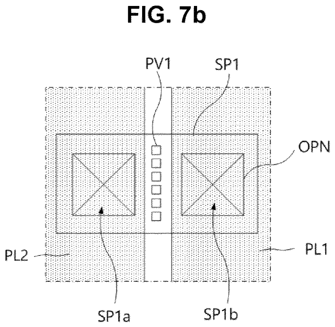

FIG. 7a is a sectional view of the memory device according to an embodiment of the present disclosure, and FIG. 7b is a plan view of a portion corresponding to P2 of FIG. 7a.

Referring to FIGS. 7a and 7b, the first cover layer CV1 is provided on the first rear metal layer BM1. The first cover layer CV1 has two openings OPN that expose the upper surface of the first signal pad SP1. The first signal pad SP1 exposed by the two openings OPN may provide the same signal, but may act as two signal pads SP1a and SP1b when viewed from the outside.

Furthermore, the openings OPN, which expose the upper surface of the first signal pad SP1, may be provided in various positions. For example, the openings OPN may be provided only between the first plane PL1 and the second plane PL2 and may partially overlap at least one of the first plane PL1 and the second plane PL2. In addition, as in this embodiment, one of the openings OPN may overlap the first plane PL 1, and the other one of the opening OPN may overlap the second plane PL2.

Likewise to the first signal pad SP1, the second signal pad SP2 may also be modified in various numbers. For example, as illustrated, the second cover layer CV2 on the second rear metal layer BM2 has three openings OPN that expose the upper surface of the second signal pad SP2. Accordingly, the second signal pad SP2 may be provided as three signal pads SP2a, SP2b, and SP2c. In the drawing according to this embodiment, the first and second signal pads SP1 and SP2 that provide the same signal are illustrated. However, when a plurality of first signal pads SP1 and/or a plurality of second signal pads SP2 are provided, the first signal pads SP1 and/or the second signal pads SP2 may be separate signal pads that apply different signals.

In an embodiment of the present disclosure, in the first structure ST1 and the second structure ST2, signals/power may be transmitted through the first and second bonding pads BP1 and BP2. However, components of the first structure ST1 and the second structure ST2 may be electrically connected by forming a through-VIA THV that penetrates the first structure ST1 and that is directly connected to the peripheral circuit PC or wiring of the second structure ST2.

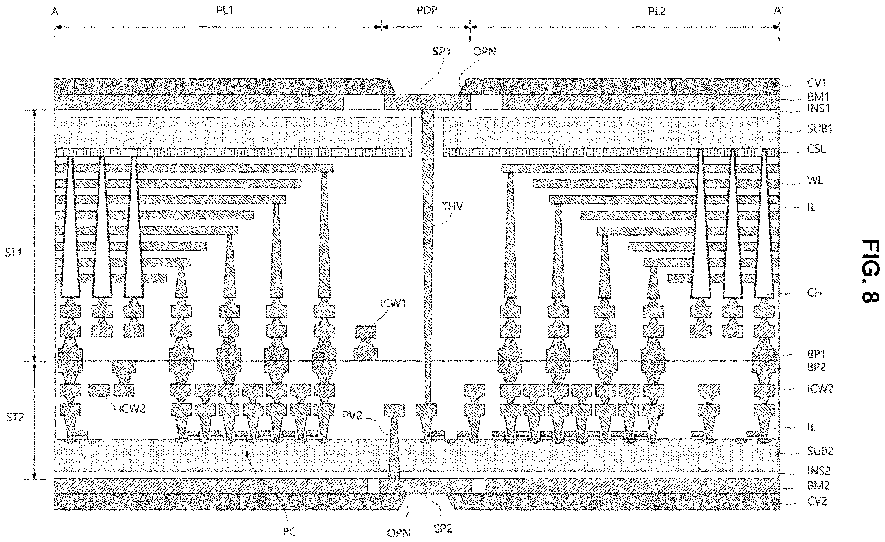

FIG. 8 is a sectional view illustrating the memory device according to an embodiment of the present disclosure, where the pad part has a through-VIA.

Referring to FIG. 8, the through-VIA THV may penetrate the second interlayer insulating layer IL of the second structure ST2 as well as the first rear insulating layer INS1 of the first structure ST1, the first substrate SUB 1, and the first interlayer insulating layer IL from a first signal wire and may be connected to the internal peripheral circuit PC or the internal connection wire of the second structure ST2.

By directly connecting the first signal pad SP1 through the through-VIA THV using a single process, wiring resistance and process complexity may be reduced.

In an embodiment of the present disclosure, the pad part may be provided in one of the row direction and the column direction, or may be provided in both the row direction and the column direction.

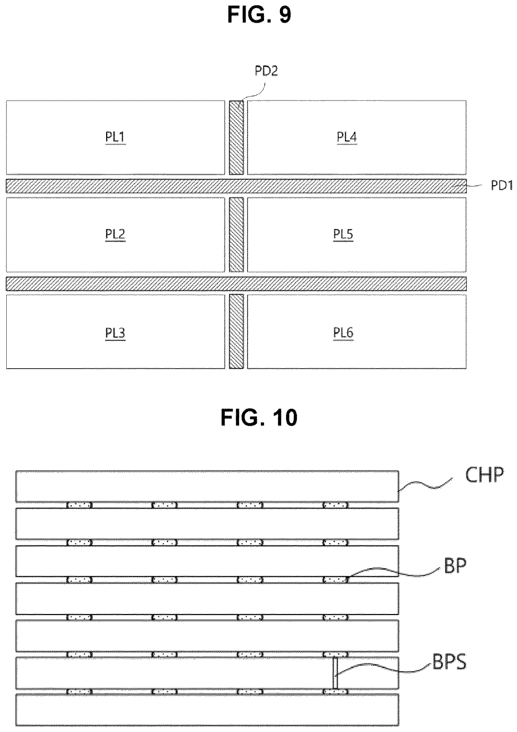

FIG. 9 is a schematic plan view illustrating the memory device according to an embodiment of the present disclosure.

Referring to FIG. 9, in the memory device in which a plurality of planes (e.g., six planes in the drawing) are disposed, the pad part PDP has a first pad part PD1 provided between two planes adjacent to each other in the first direction and a second pad part PD2 provided between two planes adjacent to each other in the second direction.

When the pad part PDP is provided in the row and column directions rather than only the row or column direction as described above, the degree of freedom in the configuration of connection between various components in the first structure ST1 and the second structure ST2 and the pad part PDP is greatly improved. In particular, unlike the first pad part PD1, the second pad part PD2 may be used to selectively apply power, or may be used as a pad for a bypass path.

For example, in an embodiment of the present disclosure, when a plurality of memory chips CHP are stacked, the pad part PDP may be used as a bypass path that passes through one or more memory chips CHP in the stacked structure in which the memory chips CHP are stacked and electrically connects non-adjacent memory chips CHP via. In this case, the bypass pad part is not connected with a memory cell in the memory chip through which the bypass path passes and the peripheral circuit.

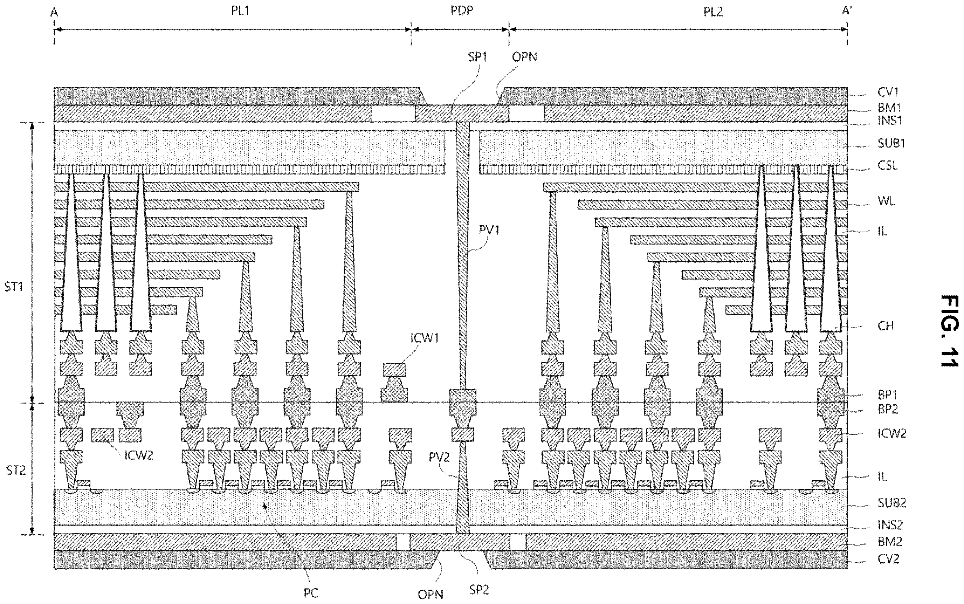

FIG. 10 is a schematic sectional view of the memory device having a bypass pad part according to an embodiment of the present disclosure, and FIG. 11 is a sectional view illustrating a memory chip having the bypass pad part.

Referring to FIGS. 10 and 11, the first and second signal pads SP1 and SP2 in one memory chip CHP may be directly connected without connection with other components (e.g., the peripheral circuit PC) between the first and second structures ST1 and ST2. That is, between the first and second planes PL1 and PL2, the first signal pad SP1 is connected to the first bonding pad BP1 through the first pad VIA PV1, which penetrates the first rear insulating layer INS1, and the first internal connection wire ICW1, the second signal pad SP2 is connected to the second bonding pad BP2 through the second internal connection wire ICW2, and the first and second boding pads BP1 and BP2 are directly bonded to each other. Accordingly, an electrical connection between the first signal pad SP1 and the second signal pad SP2 may be substantially the same as a single wire between the first signal pad SP1 and the second signal pad SP2. When the first signal pad SP1 and the second signal pad SP2 are connected to a memory chip CHP disposed on an upper side of a corresponding memory chip CHP and a memory chip CHP disposed on a lower side of the corresponding memory chip CHP, the electrical connection between the first signal pad SP1 and the second signal pad SP2 may be used as a bypass wire BPS connecting the memory chip CHP disposed on the upper side and the memory chip CHP disposed on the lower side.

The memory device having the above-described structure according to the embodiment of the present disclosure reduces and/or minimizes transmission paths of various signals including power to reduce signal loading time, thereby improving signal transmission efficiency.

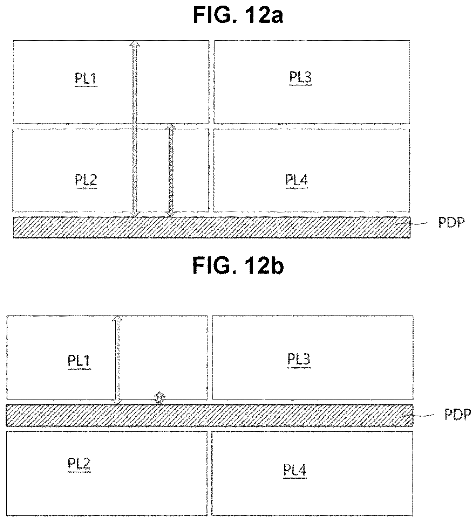

FIGS. 12a and 12b are schematic plan views illustrating the shortest signal transmission paths in an existing memory device and the memory device according to an embodiment of the present disclosure, where the shortest signal transmission paths depending on positions are illustrated by arrows.

Referring to FIGS. 12a and 12b, in the existing memory device, a pad part PDP connected with an external component is disposed at an edge of a region in which planes are arranged. This is to connect a stacked structure by wire bonding when manufacturing the memory device having the plurality of planes.

In this case, when a plane far away from the edge receives a signal from the pad part, a signal transmission path is lengthened, and therefore loading a signal including power is delayed. The occurrence of skew due to the loading difference has to be overcome by mounting an additional buffer circuit or additionally allocating a contact connecting an inner wire and the pad part. However, additionally mounting a skew compensation circuit in the memory device causes problems in package compactness, optimization, and mass production in the manufacture of memory. In addition, even though an inter-plane pad structure is applied to the inside between the planes, a redistribution line (RDL) is essential for the conventional connection, and the arrangement and use of the additional redistribution line increase resistance in a turned-on state of the memory, increase the size of the main driver, and cause a disadvantageous situation as the redistribution line serves as a stub.

In contrast, since the pad part is provided between the planes in the memory device according to the embodiment of the present disclosure, the transmission path along which the inner planes receive signals from the pad part is greatly reduced. Accordingly, the loading of signals and power is reduced. In particular, the loading of the signal path from the plane may be reduced, and thus resistance may be reduced by up to about 90%. Furthermore, power or signal skew is reduced and/or minimized for each plane, and thus it is easy to design each component in the structure, particularly, the peripheral circuit.

Moreover, when the rear metal layers of the first and second structures are used as pad parts, a redistribution line required when memory chips are connected by wire bonding is unnecessary. In addition, since an additional stepped arrangement for wire bonding is unnecessary, the area of a package is reduced, and as a result, a limitation in size is reduced in the manufacture of the memory device.

The present disclosure provides the high-quality memory device having a small volume while solving problems such as a signal delay.

While the present disclosure has been described with reference to embodiments thereof, it will be apparent to those of ordinary skill in the art that various changes and modifications may be made thereto without departing from the scope of the following claims.

For example, in an embodiment of the present disclosure, as an example, the memory device is a VNAND flash memory device. However, the present disclosure may be applied to memory devices having other structures without departing from the scope of the appended claims.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU) , an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

## Claims

1. A memory device comprising:
a first structure (ST1) having a plurality of planes (PL1-PL6) and a pad part (PDP; PDP1, PDP2) between two planes adjacent to each other among the plurality of planes (PL1-PL6), each of the plurality of planes (PL1-PL6) including a memory cell; and
a second structure (ST2) bonded to the first structure (ST1), the second structure (ST2) including a peripheral circuit, wherein
the plurality of planes (PL1-PL6) are minimum units in which operations are independently performed,
the plurality of planes (PL1-PL6) are in an n x m array having rows and columns,
n and m each independently are integers of 2 or larger, and
the pad part (PDP; PDP1, PDP2) is between the rows of the n x m array, the columns of the n x m array, or both the rows of the n x m array and the columns of the n x m array.

2. The memory device of claim 1, wherein
a first surface of the first structure (ST1) faces the second structure (ST2),
a second surface of the first structure (ST1) faces away from the first surface of the first structure (ST1),
a first surface of the second structure (ST2) faces the first structure (ST1), and
a second surface of the second structure (ST2) faces away from the first surface of the second structure (ST2), and
the pad part (PDP; PDP1, PDP2) includes a first signal pad (SP1) on the second surface of the first structure and a second signal pad (SP2) on the second surface of the second structure (ST2).

3. The memory device of claim 2, wherein
the first signal pad (SP1) is one among a number of first signal pads on the second surface of the first structure (ST1),
the second signal pad (SP2) is one among a number of second signal pads on the second surface of the second structure (ST2), and
the number of first signal pads and the number of second signal pads differ from each other.

4. The memory device of claim 2 or 3, further comprising:
a first rear metal layer (BM1) on the second surface of the first structure (ST1); and
a second rear metal layer (BM2) on the second surface of the second structure (ST2), wherein
a material of the first signal pad (SP1) is the same as a material as the first rear metal layer (BM1), and
a material of the second signal pad (SP2) is the same as a material of the second rear metal layer (BM2).

5. The memory device of claim 4, further comprising:
a first cover layer (CV1) on the first signal pad (SP1) and the first rear metal layer (BM1), the first cover layer (CV1) having an opening (OPN) exposing an upper surface of the first signal pad (SP1); and
a second cover layer (CV2) on the second signal pad and the second rear metal layer (BM2), the second cover layer (CV2) having an opening (OPN) exposing an upper surface of the second signal pad (SP2).

6. The memory device of claim 5, wherein
the opening (OPN) of the first cover layer (CV1) is one of a plurality of openings (OPN) in the first cover layer (CV1) exposing the upper surface of the first signal pad (SP1),
the opening (OPN) of the second cover layer (CV2) is one of a plurality of openings (OPN) in the second cover layer (CV2) exposing the upper surface of the second signal pad (SP2), or
the first cover layer (CV1) includes the plurality of openings (OPN) in the first cover layer (CV1) exposing the upper surface of the first signal pad (SP1) and the second cover layer (CV2) includes the plurality of openings (OPN) in the second cover layer (CV2) exposing the upper surface of the second signal pad (SP2).

7. The memory device of claim 5 or 6, wherein
the opening (OPN) of the first cover layer (CV1) exposing the upper surface of the first signal pad (SP1) at least partially overlaps a first plane and a second plane among the plurality of planes (PL1-PL6) when viewed from above a plane.

8. The memory device of any one of claims 3 to 7, wherein
the pad part (PDP; PDP1, PDP2) further includes a pad VIA (PV1) overlapping the first signal pad (SP1) when viewed from above a plane, and
the pad VIA (PV1) penetrates the first structure (ST1) between a first plane and a second plane among the plurality of planes (PL1-PL6).

9. The memory device of any one of claims 3 to 8, wherein the first signal pad (SP1) and the second signal pad (SP2) do not overlap each other when viewed from above a plane.

10. The memory device of any one of claims 1 to 9, wherein
the columns of the plurality of planes (PL1-PL6) extend in a first direction,
the rows of the plurality of planes (PL1-PL6) extend in a second direction, and
the pad part (PDP1, PDP2) includes a first pad part (PDP1) between two planes arranged in the first direction and a second pad part (PDP2) between two planes arranged in the second direction.

11. The memory device of claim 10, wherein at least one of the first pad part (PDP1) and the second pad part (PDP2) is connected to the memory cell of a corresponding plane among the plurality of planes (PL1-PL6), the peripheral circuit, or both peripheral circuit and the memory cell of the corresponding plane.

12. The memory device of any one of claims 1 to 11, wherein
the first structure (ST1) is one of a plurality of first structures in the memory device,
the second structure (ST2) is one of a plurality of second structures (ST2) in the memory device,
the memory device includes two or more memory chips stacked on each other to provide stacked memory chips, and
each memory chip of the two or more memory chips is constituted by a corresponding one of the first structures and a corresponding one the second structures stacked on each other.

13. The memory device of claim 12, wherein
the stacked memory chips are bonded by flip-chip bonding.

14. The memory device of any one of claims 1 to 13, wherein the pad part (PDP; PDP1, PDP2) further includes a through-VIA (THV) penetrating the first structure (ST1) and connecting to the peripheral circuit.

15. The memory device of any one of claims 1 to 14, wherein
the first structure (ST1) is one of a plurality of first structures, and
the plurality of first structures are sequentially stacked on the second structure (ST2) and directly bonded to the second structure (ST2).
